# FASCICULE DE BREVET EUROPEEN

(11) **EP 2 192 081 B1**
(45) Date de publication et mention de la délivrance du brevet: **16.10.2013**
(21) Numéro de dépôt: 09176781.4
(22) Date de dépôt: 23.11.2009
(51) Int. Cl.: B81C 1/00, H01L 51/44

(54) **Procédé de réalisation d'une matrice de rétention et comprenant un liquide fonctionnel**
Herstellungsverfahren für Speicherarray, das eine Funktionsflüssigkeit enthält
Method of producing a retention array containing a functional fluid

(30) Priorité: 27.11.2008 FR 0858058
(43) Date de publication de la demande: 02.06.2010
(73) Titulaire: Commissariat à l'Énergie Atomique et aux Énergies Alternatives, 75015 Paris (FR)
(72) Inventeur: Fribourg-Blanc, Eric, Ho Chi Minoici (VN); Le Calvez, Stéphanie, 38360, SASSENAGE (FR); Mourey, Bruno, 38500, COUBLEVIE (FR)
(74) Mandataire: Ilgart, Jean-Christophe

(56) Documents cités:
- WO-A-99/45143
- US-A1- 2004 029 303
- NUNC: "Tapes, Lids and Mats" ANNOUNCEMENT NUNC INTERNATIONAL,, 1 janvier 2006 (2006-01-01), pages 1-4, XP007910887
- KUO ET AL: "Monolithic integration of well-ordered nanoporous structures in the microfluidic channels for bioseparation" JOURNAL OF CHROMATOGRAPHY, ELSEVIER SCIENCE PUBLISHERS B.V. AMSTERDAM, NL, vol. 1162, no. 2, 4 août 2007 (2007-08-04), pages 175-179, XP022185545 ISSN: 0021-9673

## Description

### DOMAINE TECHNIQUE

L'invention se rapporte à la réalisation d'un dispositif comprenant au moins un liquide fonctionnel, en particulier d'un dispositif à microcavités remplies de liquide fonctionnel.

Elle peut s'appliquer notamment au domaine de l'optique pour la réalisation de surface à transmission d'indice de réfraction déterminé ou variable spatialement.

L'invention concerne également un procédé amélioré de remplissage d'une ou plusieurs microcavités à l'aide d'un liquide, et de fabrication d'un dispositif comprenant une ou plusieurs microcavités fermées remplies d'un liquide fonctionnel.

### ÉTAT DE LA TECHNIQUE ANTÉRIEURE

Pour certaines applications, notamment optiques, on peut chercher à confiner un liquide fonctionnel à la surface d'un substrat afin de limiter l'étalement ou/et l'évaporation du liquide.

Par « liquide fonctionnel », on entend un liquide formé d'une ou plusieurs substances choisies pour leurs propriétés spécifiques, fonction de leur application, par exemple des propriétés optiques, d'absorption ou d'indice de réfraction dans le cas d'applications optiques, ou par exemple des propriétés électriques, en particulier de conduction électrique lorsque par exemple, le liquide fonctionnel forme un électrolyte dans le cas par exemple de condensateurs, ou de piles photovoltaïques à électrolyte liquide.

La demande de brevet US 2004/029303 A1 décrit la production d'une matrice de rétention comprenant un fluide. Selon ce document on forme d'abord des cavités dans un substrat et on dépose un matériau poreux dedans. Les cavités sont mises en contact avec un échantillon liquide. Le liquide est donc piégé dans le matériau poreux.

Classiquement, pour limiter l'étalement d'un liquide sur un substrat, un traitement de surface du substrat peut être effectué, afin de modifier la mouillabilité du liquide à la surface du substrat. Dans le cas où plusieurs liquides fonctionnels différents sont dispensés, une éventuelle modification de la mouillabilité du substrat pour chacun des liquides pourrait s'avérer délicate, dans la mesure où elle peut nécessiter un traitement de surface approprié pour chacun des liquides et éventuellement d'appliquer différents traitements de surface localisés.

Un autre moyen pour empêcher l'évaporation d'un liquide sur un substrat est de faire en sorte d'assurer au moins une pression de vapeur saturante dudit liquide au-dessus du substrat, ce qui en général pose problème.

Il se pose le problème de trouver un nouveau procédé de réalisation d'un dispositif comportant au moins un liquide fonctionnel et qui ne comporte pas les inconvénients mentionnés ci-dessus.

### EXPOSÉ DE L'INVENTION

La présente invention concerne un procédé de réalisation d'un dispositif doté d'une ou plusieurs cavités remplies d'au moins un liquide piégé dans un matériau poreux de rétention, comprenant les étapes de :
a) formation d'un matériau poreux dans une ou plusieurs cavités formées dans au moins une couche déposée sur un support, une ou plusieurs parois réalisées dans ladite couche séparant entre elles les cavités,
b) remplissage d'au moins une des dites cavités à l'aide d'au moins un liquide dit « liquide fonctionnel »,
c) formation d'une couche de fermeture permettant de fermer les dites cavités.

Les cavités peuvent être des microcavités. Par « micro-cavités », on entend des cavités dont la dimension, c'est-à-dire la plus petite dimension des cavités autre que leur profondeur, peut être comprise entre 1 µm et plusieurs centaines de µm, et par exemple comprise entre 10 et 500 µm.

Le matériau poreux est prévu pour former un moyen de rétention ou une matrice de rétention dudit liquide donné.

On peut ainsi obtenir des zones de rétention localisées.

Selon une première possibilité de mise en oeuvre du matériau poreux, ledit matériau poreux et lesdites parois des cavités peuvent être formés à partir d'une même couche.

On peut tout d'abord réaliser les parois, puis, dans des zones de cette même couche distinctes des parois, former des porosités.

Pour cela, le procédé peut comprendre à l'étape a) des étapes de :
- dépôt d'une couche d'au moins un matériau donné, tel qu'un matériau sol-gel, le matériau donné étant apte à être mis sous forme de gel et étant photosensible,
- exposition à un rayonnement lumineux de premières parties de la couche dudit matériau donné, tandis que des deuxièmes parties de la couche dudit matériau donné sont protégées dudit rayonnement, aux premières parties ou les deuxième parties étant destinées à former lesdites parois des dites cavités
- formation de porosités dans certaines parties de la couche.

Selon une deuxième possibilité de mise en oeuvre du matériau poreux, après réalisation des dites cavités, la formation du dit matériau poreux à l'étape a) peut comprendre des étapes de :
- dépôt dans au moins une des dites cavités d'un liquide donné comportant des particules telles que des billes, en suspension,
- suppression dudit liquide donné, de manière à former un amas de particules, en particulier un amas de billes.

L'amas de billes peut ainsi former un matériau poreux.

Selon une variante, la réalisation du matériau poreux, peut comprendre des étapes supplémentaires après réalisation du dit amas de billes, en particulier des étapes :
- d'infiltration de l'amas de billes par un liquide destiné à être solidifié,
- de solidification dudit liquide,
- d'élimination des dites particules.

Selon une troisième possibilité de mise en oeuvre du matériau poreux, après formation des dites cavités, la formation du matériau poreux à l'étape a) peut comprendre des étapes de :
- dépôt dans au moins une des dites cavités d'un mélange, d'au moins un matériau donné liquide susceptible d'être mis sous forme de gel, et d'au moins un solvant,
- traitement dudit mélange de manière à mettre sous forme de gel ledit matériau donné,
- élimination dudit solvant.

Le matériau poreux peut être un aérogel ou être formé à l'aide d'un matériau porogène.

Le procédé comprend en outre une étape c) de formation d'au moins une couche, ou membrane, de fermeture desdites cavités. Cette membrane permet, avec le matériau poreux d'éviter l'évaporation du liquide des cavités.

Selon une possibilité, en particulier lorsque le liquide donné ne remplit pas complètement le volume de la ou des cavités, la membrane ou couche de fermeture peut être formée d'un matériau infiltré dans le matériau poreux et solidifié, par exemple un matériau polymère infiltré dans le matériau poreux et solidifié. Cela permet d'assurer une bonne tenue mécanique de la fermeture.

Lorsque le liquide donné remplit totalement le volume du matériau poreux présent dans la cavité, la membrane ou couche de fermeture peut être à base d'un matériau par exemple polymère recouvrant le liquide infiltré et retenu dans le matériau poreux.

La membrane ou couche de fermeture peut être formée en délivrant sur le matériau poreux de rétention contenant le liquide donné, un autre liquide, polymérisable, puis par polymérisation dudit autre liquide.

Selon une mise en oeuvre possible, la couche de fermeture des cavités, réalisée à l'étape c), peut, être à base d'une colle, par exemple transparente à un rayonnement dans le domaine du visible pour une application optique.

La couche de fermeture peut être réalisée à une pression comprise entre 1 et 500 mbar, ou sous vide primaire. La matrice de rétention ou le matériau de rétention, permet alors d'empêcher une éventuelle évaporation du liquide fonctionnel lors de la réalisation de la couche de fermeture.

Pour une application optique, le liquide de remplissage des cavités peut être choisi par exemple parmi l'un des liquides suivants : huile minérale, ou huile d'encre d'imprimerie, huile silicone, gel thermoréversible à base d'un liquide et d'un gélifiant tel que le N-benzyloxycarbonyl-L-alanine-4-hexadecanoyl-2 nitrophenyl ester avec du cyclohexane.

Selon une mise en oeuvre possible, plusieurs cavités séparées peuvent être formées, l'étape b) comportant alors le remplissage de plusieurs desdites cavités à l'aide dudit liquide donné, la couche de fermeture formée à l'étape c) et les cavités formant plusieurs enceintes fermées séparées remplies dudit liquide donné.

Selon une variante, l'étape b) peut comporter une dispense dudit liquide donné dans au moins une desdites cavités, et une dispense d'au moins un autre liquide dans une ou plusieurs autres cavités.

L'invention concerne également un dispositif obtenu à l'aide d'un procédé tel que défini précédemment.

L'invention concerne ainsi la réalisation d'un dispositif comprenant au moins un liquide appelé « liquide fonctionnel » contenu dans au moins un matériau poreux de rétention, le matériau poreux et le liquide pouvant être situés dans une ou plusieurs microcavités, en particulier des cavités ou microcavités fermées par au moins une couche de fermeture.

### BRÈVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatif.
Les figures 1A à 1D illustrent un exemple de procédé suivant l'invention, de réalisation d'un dispositif comportant des microcavités remplies d'au moins un liquide fonctionnel piégé dans une matrice de rétention,
Les figures 2A-2B illustrent un autre exemple de procédé selon l'invention,
La figure 3 illustre un autre exemple de procédé selon l'invention,
Les figures 4A-4D illustrent un exemple de procédé de réalisation d'un matériau poreux,
Les figures 5A-5B illustrent un autre exemple de procédé de réalisation d'un matériau poreux,
Les figures 6A-6C illustrent un autre exemple de procédé de réalisation de microcavités remplies de matériau poreux, les cavités et le matériau étant formés à partir d'une même couche,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

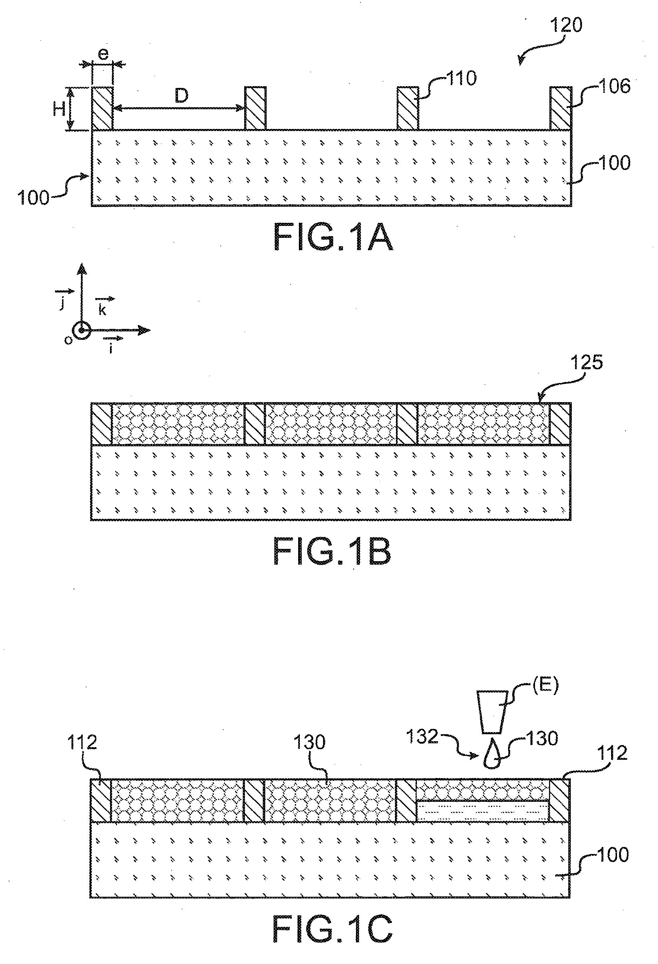

Un exemple de procédé selon l'invention, de réalisation d'un dispositif comportant une ou plusieurs cavités, en particulier des microcavités remplies d'au moins un liquide, va à présent être donné en liaison avec les figures 1A-1D.

Sur un support 100, on forme tout d'abord une ou plusieurs cavités 120 ou cuves 120 ou enceintes 120, chaque cavité 120 étant délimitée latéralement, par des parois 110 formées dans une ou plusieurs couches minces, ainsi qu'au fond, par une couche du support.

Les parois 110 des cavités 120 peuvent être réparties de manière à conférer à ces dernières une forme qui, dans le plan du substrat, peut être, selon plusieurs exemples : circulaire, ovale, carrée, rectangulaire, polygonale, ou en étoile. Un pavage du plan peut être effectué. Un tel pavage peut être organisé selon une géométrie régulière, par exemple, triangulaire, rectangulaire, ou hexagonale. On peut également mettre en oeuvre un pavage à l'aide de deux motifs par exemple avec un octogone et un carré. Toute combinaison de formes permettant de réaliser un pavage du plan peut être réalisée. Le choix du pavage est adapté en fonction de l'application prévue pour le dispositif. Les parois 110 séparant les cavités 120 assurent leur étanchéité mutuelle.

Le support 100 peut être transparent, et par exemple sous forme d'une dalle de verre de quartz ou d'une couche de matériau souple tel que du polyéthylène téréphtalate (PET).

Selon une possibilité de mise en oeuvre des cavités 120, ces dernières peuvent être réalisées par dépôt d'une couche 106, sur le support 100, puis par gravure de cette couche 106 de manière à délimiter les emplacements des parois 110 des cavités 120. La couche 106 dans laquelle on définit les cavités 120 peut être, par exemple, une couche de résine photosensible. La réalisation des cavités peut ainsi comprendre au moins une étape de photolithographie.

Selon une variante, les cavités 120 peuvent être formées à l'aide d'un procédé dans lequel on forme une couche 106 sur le support, puis on réalise les emplacements des cavités 120 par emboutissage, à l'aide d'un moule doté de motifs saillants que l'on applique par pressage sur la couche 106.

Selon une autre variante, on peut déposer une couche 106, par exemple à base de matériau polymère sur le support 100 puis graver localement cette couche 106 au travers d'un masque, par exemple par gravure plasma RIE ou haute densité avec, par exemple, un mélange de O₂, d'un gaz fluoré type SF₆ et/ou de CHF₃.

Selon une autre variante, on peut former la couche 106, par laminage sur un substrat 100 d'une couche par exemple à base de matériau polymère dans laquelle les cavités 120 ont été préalablement réalisées, par exemple par gravure.

La taille, la localisation des cavités 120 dépendent de l'application prévue pour le dispositif.

Pour une application optique, les parois 110 peuvent être formées selon une géométrie et un matériau prévus pour ne pas apporter de perturbation ou apporter des perturbations négligeables ou non visibles, sur le trajet de rayons lumineux traversant le support 100. Les parois 110 peuvent éventuellement être formées d'un matériau, transparent aux rayonnements du domaine du visible et ayant un indice de réfraction homogène. On peut par exemple réaliser les parois 110 des cavités à l'aide d'une couche 106 de résine à base d'ORMOCER ®. L'indice de réfraction de cette résine peut être adapté et modulé notamment en fonction de la proportion d'ORMOCER ®.

Les parois 110 séparant les cavités 120 peuvent avoir une épaisseur e définie dans une direction parallèle au plan principal du substrat ou support (défini sur la figure 1A par un plan parallèle au plan [O;*̅i̅*̅ ; *̅k̅*̅ ] d'un repère orthogonal [O;*̅i̅*̅ ; *̅j̅*̅ ; *̅k̅*̅ ] défini sur la figure 1A) comprise par exemple entre 0,1 µm et 5 µm, ou entre 1 µm et 3 µm.

Les parois 110 peuvent également avoir une hauteur H (H étant définie sur la figure 1A dans une direction parallèle au vecteur *̅j̅*̅ du repère orthogonal [O;*̅i̅*̅;*̅j̅*̅;*̅k̅*̅ ]) comprise par exemple entre 5 µm et 50 µm ou par exemple entre 5 µm et 50 µm, ou entre 10 µm et 30 µm.

Les cavités 120 peuvent également avoir un diamètre ou un côté ou une dimension critique D (définie sur la figure 1A dans une direction parallèle au plan [O;*̅i̅*̅;*̅k̅*̅] du repère orthogonal [O;*̅i̅*̅;*̅j̅*̅;*̅k̅*̅]) comprise par exemple entre 20 µm et 500 µm ou par exemple entre 100 µm et 300 µm.

Dans un cas où la dimension des cavités 120 est faible et par exemple comprise entre 10 et 500 µm, on appellera ces cavités des « microcavités ».

Puis (figure 1B), on forme un matériau poreux dans les cavités 120, ou on remplit les cavités 120 à l'aide d'au moins un matériau poreux 125. Le matériau poreux 125 est prévu pour jouer le rôle de matériau de rétention et est également appelé matrice de rétention de liquide(s).

Le matériau poreux 125 peut être tel qu'il présente une densité de pores importante, par exemple de sorte que la densité de matériau formant le squelette solide est inférieure à 10 mg/ml.

Le taux de porosité du matériau poreux est ajusté en fonction de l'application visée.

Pour une application optique, un contrôle de la densité du matériau poreux peut être mis en oeuvre, afin d'obtenir une faible quantité de matériau formant le squelette.

Dans le cas d'une application à un dispositif optique, le matériau poreux 125 peut être choisi de manière à avoir un indice optique et en particulier un indice de réfraction proche de celui du liquide ou des liquides destinés également à remplir les cavités 120.

Le matériau poreux 125 est de préférence un matériau à porosité ouverte dans lequel les pores communiquent entre eux et vers l'extérieur du matériau pour la majorité d'entre eux. Le seuil de tolérance de porosités non communicantes dépend de l'application visée. La porosité du matériau 125 peut être prévue en fonction de l'indice de réfraction recherché.

Selon une possibilité, le matériau poreux 125 peut être un aérogel par exemple tel qu'un aérogel de silice. On entend par « aérogel » tout au long de la présente description, un matériau poreux obtenu à partir d'extraction du liquide d'un gel. Le matériau poreux 125 peut être formé par exemple à l'aide d'un procédé sol-gel, le matériau sol-gel de base pouvant être délivré ou déposé dans les cavités 120 par un appareil du type à jet d'encre. Après formation du gel, une étape d'extraction par lyophilisation ou d'extraction supercritique peut être ensuite effectuée afin d'obtenir un aérogel.

Selon d'autres possibilités, le matériau sol-gel à partir duquel on forme le matériau poreux 125 peut être déposé par dépôt tournant (« spin coating » selon la terminologie anglo-saxonne) ou par trempage (« dipping » selon la terminologie anglo-saxonne) ou par revêtement par jet (« spray coating » selon la terminologie anglo-saxonne) ou par revêtement de type communément appelé « meniscus coating ».

Selon un exemple, le matériau poreux 125 peut être un aérogel de silice sol-gel ou un matériau hybride organique-inorganique sol-gel par exemple un matériau ORMOSIL type SiO₂-TiO₂ tel que décrit dans le document « Aerosol-gel déposition of photocurable ORMOSIL films doped with Terbium complex », de M.Langlet & al., Optical Materials, 25, (2004) 179-184.

Dans le cas où le matériau poreux 125 est un aérogel, cet aérogel peut être formé d'une structure réticulée ultra-poreuse, dont la surface spécifique peut être par exemple d'au moins 500 m²/g et dont le volume solide du matériau peut atteindre, par exemple entre 0,1 % et 10 % du volume d'une cavité 120. Le volume solide du matériau poreux peut atteindre par exemple au plus 10 % du volume d'une cavité 120 de manière à laisser de l'ordre de 90 % du volume de la cavité disponible en vue d'un remplissage par un liquide.

Selon un autre exemple, le matériau poreux 125 peut être un matériau polymère poreux, par exemple un polymère poreux formé par la polymérisation radicalaire de trimethylolpropane trimethacrylate à l'aide d'au moins un matériau porogène associé tel que par exemple de l'acétone, du chlorohexanone, ou du toluène.

Le matériau poreux peut comporter des pores ou porosités de diamètre qui peut être compris entre plusieurs nanomètres et une dizaine de micromètres.

Après avoir formé le matériau poreux 125 dans les microcavités, on peut réduire le volume du squelette solide de ce matériau, et augmenter la taille des pores.

Par exemple, lorsque le matériau poreux 125 est un aérogel, pour augmenter la taille des pores, on peut effectuer par exemple une dissolution contrôlée du matériau aérogel, ou par exemple dans le cas d'un matériau poreux à base de silice, de l'acide fluorhydrique peut être utilisé afin d'augmenter la taille des pores et de faciliter d'une part la pénétration du liquide, et d'autre part de réduire les effets de diffusion optique. Cela peut être notamment réalisé par un procédé de traitement à l'acide fluorhydrique en phase gazeuse. La dilution de l'acide dans la phase gazeuse permet de régler la cinétique de dissolution du matériau poreux et donc la fraction restante.

Pour une application optique du dispositif, le matériau poreux 125 est choisi de préférence de sorte que l'épaisseur moyenne des parois des pores est inférieure à la gamme des longueurs d'onde du rayonnement utilisé. Par exemple, pour un rayonnement visible, cette épaisseur est inférieure à 200 nm.

Plusieurs exemples de réalisation détaillés du matériau poreux 125 vont à présent être donnés.

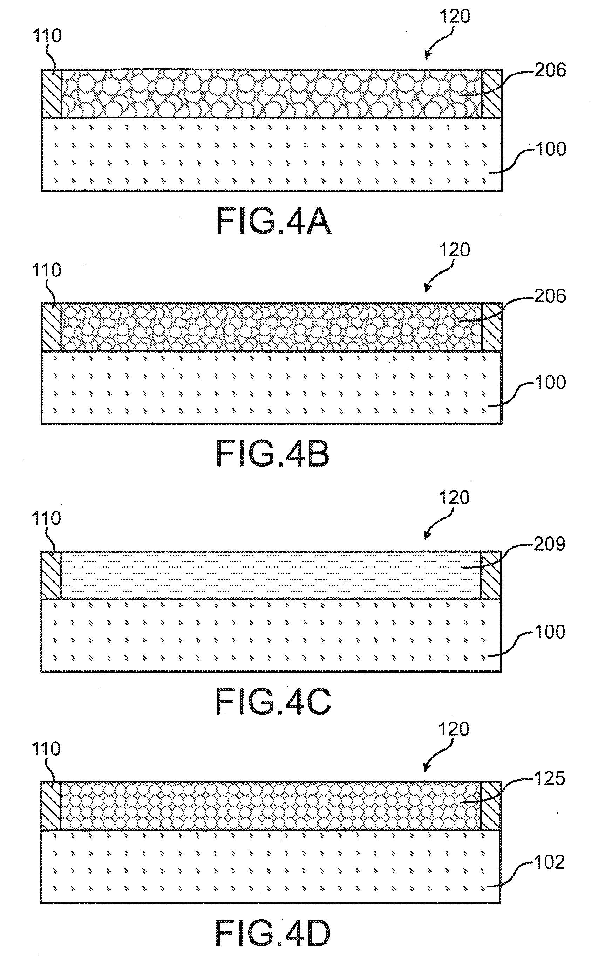

Un premier exemple détaillé de procédé de formation du matériau de rétention poreux 125 est donné en liaison avec les figures 4A-4D.

Pour réaliser ce matériau, une technique du type de la technique opale infiltrée est effectuée.

On effectue tout d'abord un dépôt sur le support 100 d'un liquide comportant des billes 206 en suspension (figure 4A).

Les billes 206 peuvent être par exemple des billes de polystyrène ayant un diamètre qui peut être compris par exemple entre plusieurs nanomètres et une dizaine de micromètres. Les dimensions interstitielles entre les billes 206 sont faibles, c'est à dire dans le cas d'une application optique, nettement inférieures à la gamme des longueurs d'onde du domaine visible. Le diamètre maximal des billes peut être choisi de manière à être inférieur ou égal à deux fois la hauteur des parois 110, et de préférence inférieur ou égal à la moitié de la hauteur des parois 110.

Une telle distribution peut être par exemple obtenue par mélange par centrifugation par exemple de plusieurs populations de billes. La répartition des diamètres est choisie de préférence de manière à limiter la présence de porosité fermée. La répartition des diamètres de billes peut être optimisée pour obtenir une porosité totalement ouverte.

Les billes de polystyrène peuvent être contenues dans un liquide. Une sédimentation en un assemblage compact peut être ensuite réalisée par centrifugation, tel que cela est décrit par exemple dans le document : « Inverse silica opal photonic crystals for optical sensing applications », Y. Nishijima, K. Ueno, S. Juodkazis, et al., Optics Express, 15(20), 12979, 2007, ou dans le document : « Opal circuits of light-planarized microphotonic crystal chips », S.M. Yang, H. Miguez, G.A. Ozin, Advanced Functional Materials, 12, 425, 2002.

Le liquide comportant les billes en suspension peut être un solvant, ou un liquide destiné à former le constituant final du matériau poreux après avoir été solidifié.

Dans le cas où le liquide contenant les billes 206 est un solvant, on effectue un séchage à une température compatible avec le support 100, par exemple inférieure à 150°C ou à 100°C. Les billes peuvent être alors compactées lors du séchage.

La couche de billes formée suite au séchage, est ensuite infiltrée par un autre matériau liquide approprié 209.

Les billes sont ensuite éliminées, par exemple par dissolution. Suite à cette dissolution, on obtient un matériau poreux 125.

Un procédé de nettoyage en phase gazeuse peut éventuellement être effectué afin de compléter cette dissolution.

On peut mettre en oeuvre un sol-gel de silice, tel que par exemple du tétraethoxysilane d'oxyde de titane tel que par exemple de l'éthoxyde de titane. Un gel ainsi obtenu est alors séché à une température adéquate, par exemple inférieure à 150°C ou à 100°C.

Dans le cas de billes polymères, la dissolution peut être réalisée par exemple à l'aide d'éthyl-acétate, ou de tétrahydrofurane ou de tout autre moyen approprié.

Selon une autre possibilité de réalisation de l'étape décrite précédemment en liaison avec la figure 4B, une solution de monomères organiques peut être éventuellement utilisée afin d'infiltrer l'assemblage de billes 206. Une telle solution a pour avantage de ne pas nécessiter une température élevée de séchage. La solution de monomères organiques est choisie de telle sorte à pouvoir réticuler par traitement thermique ou par insolation UV, ainsi que de façon à ce que le polymère infiltré une fois réticulé n'est pas soluble dans le dissolvant utilisé ensuite pour éliminer les billes. Le monomère organique peut éventuellement être une résine photosensible.

Selon une variante, les billes de polystyrène peuvent être remplacées par exemple par des billes de silice infiltrées par une solution polymérisable. Dans ce cas, les billes de silice sont ensuite éliminées par une solution d'acide fluorhydrique ou un traitement par acide fluorhydrique en phase gazeuse.

Ainsi, dans l'exemple de réalisation de la matrice de rétention qui vient d'être donné, on délivre tout d'abord dans les cavités 120 un liquide à base d'un solvant contenant des billes (figure 4A).

Le solvant est évaporé par une étape de séchage (figure 4B).

On infiltre ensuite l'assemblage de billes qui peut avoir été compacté lors du séchage par un liquide 209 (figure 4C).

On solidifie ensuite le liquide 209 infiltré.

Enfin on élimine les billes, de manière à obtenir un matériau poreux 125 dont le liquide 209 solidifié forme le squelette (figure 4D).

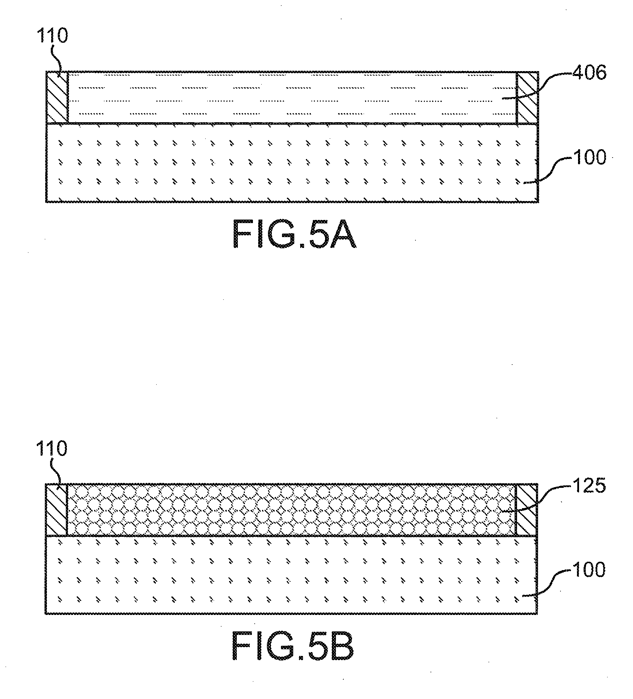

Un deuxième exemple de réalisation de la matrice de rétention va être donné en liaison avec les figures 5A-5B.

Dans cet exemple, le matériau poreux 125 peut être réalisé à l'aide d'une technique d'extraction sol-gel par lyophilisation.

Un matériau 406, par exemple de type sol-gel est tout d'abord déposé dans les cavités 120 sous forme d'un liquide comportant au moins un solvant. Dans cet exemple on dépose le matériau 406 sol-gel dans les cavités 120 avec ou sans contrôle spécifique sur l'épaisseur déposée. Si on souhaite un contrôle de l'épaisseur déposée, on peut délivrer ce matériau 406 par un équipement mettant en oeuvre une technique de jet d'encre ou une technique précise équivalente. Un dépôt de type communément appelé par « spray coating» ou centrifugation peut être également utilisé (figure 5A).

Le matériau 406 sol-gel sous forme liquide est ensuite refroidi de manière à être solidifié. Pour refroidir et solidifier, on peut placer le substrat 100 dans un dispositif de congélation. Suivant le choix des solvants présents dans le matériau sol-gel, il est possible de solidifier le matériau sol-gel à une température suffisante pour ne pas détériorer le substrat 100. Le ou les solvants présents dans le sol-gel peu(ven)t être sublimé(s) par extraction sous vide en plaçant le dispositif en cours de réalisation dans une enceinte sous vide primaire. L'apport d'une énergie thermique contrôlée permet alors de réaliser la sublimation des solvants. Une fois l'ensemble des solvants extraits, on peut obtenir un matériau poreux 125 sous forme d'un aérogel (figure 5B).

Une fois le retour à pression et température ambiantes, dans un cas où on aurait dispensé le liquide précurseur de l'aérogel, sans contrôle volumique précis, il est possible de réaliser un polissage mécanico-chimique (CMP) pour supprimer le matériau en excédant dépassant au dessus des parois 110 des cavités 120.

Un troisième exemple de réalisation du matériau de rétention va être donné. Dans cet exemple, le matériau poreux 125 peut être obtenu à l'aide d'une technique d'extraction supercritique d'un matériau sol-gel. Un procédé de séchage supercritique au CO₂ peut être par exemple effectué en appliquant une pression élevée, par exemple de l'ordre de 74 bar, sous une température proche de l'ambiante. Dans ce cas le support 100 est prévu pour résister à une telle pression. Dans cet exemple, le support 100 peut être formé d'au moins une couche à base de verre, ou d'un film polymère tel que du PET adhérant sur une autre couche, par exemple à base d'acrylate. Pour protéger le dispositif en cours de réalisation d'un phénomène de solvatation du CO₂ lors de l'extraction supercritique un joint tel qu'un joint de colle époxy polymérisée peut être utilisé.

Pour ce procédé d'extraction par CO₂ supercritique, le matériau sol-gel adaptée est tout d'abord délivré par une technique adaptée, par exemple une technique de type jet d'encre, dans les cavités 120. Le matériau de départ utilisé pour former le matériau poreux peut être à base de silice, ou un autre matériau susceptible d'être mis sous forme d'un gel inorganique.

Ensuite, on met sous forme de gel du matériau avec lequel on a rempli les cavités 120. Le dispositif en cours de réalisation peut être ensuite porté aux conditions supercritiques du CO₂ dans un autoclave adapté, afin de réaliser une extraction.

Selon une autre possibilité de réalisation, différente des trois exemples décrits précédemment, dans lesquels on remplissait les cavités de matériau poreux, une fois avoir formé ces dernières, on peut réaliser le matériau poreux remplissant les cavités 120, à partir d'une même couche de matériau que les parois 110.

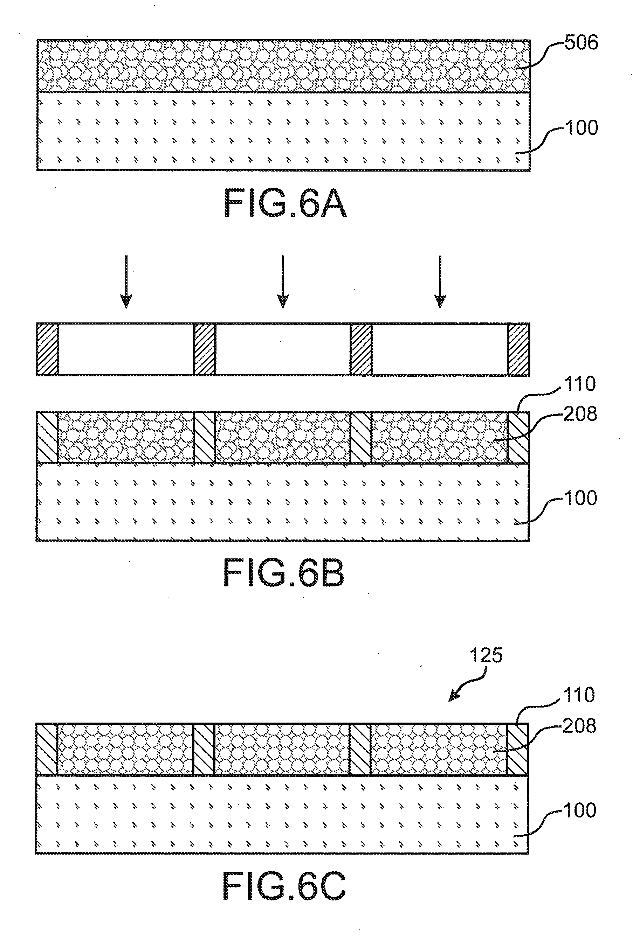

Cette autre possibilité de réalisation du matériau poreux 125 est donnée sur les figures 6A-6C.

Pour cela, on dépose sur le support 100 une couche de matériau 506 destinée à former les parois 110 (figure 6A). Ce matériau 506 peut être par exemple une résine photosensible telle qu'une résine à base d'ORMOCER®.

Les parois 110 peuvent être formées par exemple par photolithographie du matériau 506. Les parties insolées sont développées, et destinées à former les parois 110 (figure 6B).

Ensuite, on effectue un procédé d'extraction des parties non insolées du matériau 506, de manière à former un matériau poreux 125 par exemple à base d'aérogel (figure 6C).

Un avantage de cette mise en oeuvre est que le matériau poreux 125 présente une épaisseur identique à la hauteur des parois 110 des cavités 120.

Selon l'exemple qui vient d'être donné, le matériau poreux 125 est réalisé à partir d'une même couche de matériau sol-gel que les parois 110 des microcavités.

Les cavités 120 sont réalisées par dépôt d'une couche de matériau sol-gel, puis par photolithographie. Puis, après exposition du matériau sol-gel, on effectue un recuit. Le matériau sol-gel restant à l'intérieur des cavités subit un traitement de séchage par exemple par lyophilisation de manière à former le matériau poreux 125. Cette mise en oeuvre présente pour avantage notamment celui d'éviter une étape de polissage CMP du matériau poreux 125 une fois avoir rempli les cavités.

Des exemples de réalisation du matériau poreux 125, également appelée matrice de rétention, dans des cavités, en particulier des microcavités, formées sur un support 100 viennent d'être donnés.

Les cavités peuvent être réalisées à partir d'un matériau photosensible de polarité négative, mais également selon une variante, avec un matériau photosensible de polarité positive.

Après avoir formé le matériau poreux 125, on effectue un remplissage des cavités 120 à l'aide d'un liquide donné 130 ou de plusieurs liquides donnés (figure 1C).

Le liquide 130 peut être un liquide dit « fonctionnel » c'est à dire choisi pour des propriétés spécifiques. Dans le cas d'une application à un dispositif optique, le liquide fonctionnel 130 peut être choisi pour des propriétés optiques spécifiques telles que son indice de réfraction, ou/et sa capacité d'absorption lumineuse.

Le liquide donné 130 peut être choisi de manière à avoir un indice de réfraction proche de celui du matériau poreux 125. De préférence, pour une application optique, le matériau poreux 125 est formé de sorte que plus la différence entre l'indice de réfraction du liquide 130 infiltrant le matériau poreux 125 et l'indice de réfraction de ce matériau poreux 125 est grande, et plus la fraction de porosités fermées dans le matériau poreux est limitée.

Selon plusieurs exemples, le liquide fonctionnel donné 130 peut être : une huile minérale telle la gamme Isopar ® produite par la société Exxon Chemicals, ou une huile du type de celles employées dans les encres d'imprimerie, (jet d'encre ou offset), une huile silicone, ou un gel thermoréversible à base d'un liquide et d'un gélifiant par exemple tel que le : N-benzyloxycarbonyl-L-alanine-4-hexadecanoyl-2-nitrophenyl ester avec du cyclohexane.

Le remplissage peut être réalisé par un équipement E visant l'intérieur des cavités 120 et projetant le matériau 130 liquide sous forme d'un jet ou de gouttes 132, d'un volume qui peut être de l'ordre du picolitre ou d'une ou plusieurs dizaines de picolitres.

L'équipement E utilisé pour le remplissage des cavités 120, peut être prévu pour délivrer un liquide 130 selon une technique semblable à celle de la technique par jet d'encre et éventuellement semblable à la technique utilisée pour délivrer le matériau poreux 125 dans les cavités 120.

Le liquide 130 peut être choisi notamment de manière à présenter une bonne mouillabilité avec le matériau poreux 125, de sorte qu'il se répartisse dans tous les pores du matériau poreux 125. A cette fin, le liquide choisi peut contenir des surfactants permettant d'abaisser la tension de surface du liquide et de faciliter son infiltration dans le matériau poreux 125 présent dans les cavités 120 en particulier lorsque le diamètre des pores est au moins supérieure à 500 nm.

Le matériau liquide 130 peut comporter un ou des solvants organiques. Selon un exemple, le solvant utilisé peut être un solvant ayant une faible pression de vapeur saturante tel que du polyphenyl ether SANTOVAC® 5 ou une huile silicone comme par exemple un solvant tel que le di- methicone ou trimethicone ou un dérivé de l'un ou l'autre de ces solvants organiques.

Dans un cas où par exemple, pour favoriser l'obtention d'un matériau poreux 125 hautement poreux à base de sol-gel de silice, un matériau hydrophobe, tel que par exemple du hexaméthyldisilazane, a été utilisé afin de réduire certains effets néfastes d'un séchage supercritique ou de se dispenser d'une étape de séchage supercritique, il est ensuite possible de modifier l'état de surface du matériau poreux 125 par un traitement de photo-calcination de type UV/ozone pour contrôler l'énergie de surface et l'affinité chimique de ce matériau 125 avec un liquide de remplissage.

La porosité du matériau 125 est prévue suffisamment importante pour permettre au liquide fonctionnel 130 de s'infiltrer au moment de son dépôt.

Dans le cas d'une application optique du dispositif, en formant des microcavités remplies de matériau poreux 125 contenant du liquide 130, on limite ou on élimine la formation de ménisques à l'origine d'effets optiques indésirables. Le liquide 130 s'imprègne dans le matériau poreux 125 et est retenu par effet capillaire. Ce liquide 130 est ainsi piégé dans le matériau poreux 125.

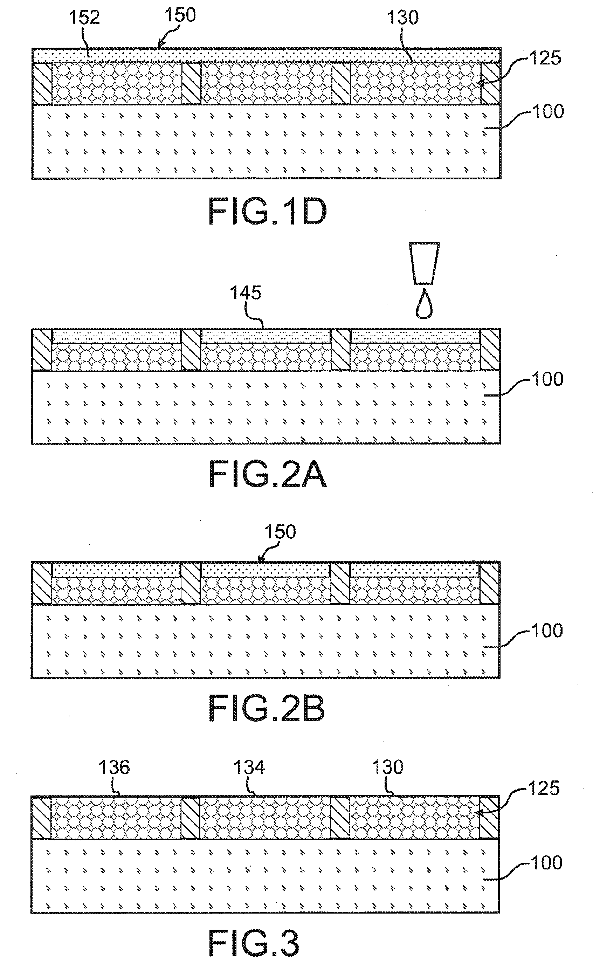

Ensuite, (figure 1D) on effectue le dépôt d'une couche 150 de fermeture des cavités. La couche de fermeture peut être formée sur le sommet 112 des parois 110 et sur la surface du matériau poreux 125 imprégné du liquide 130 ou au niveau de la partie supérieure du matériau poreux 125.

La couche de fermeture 150 est prévue notamment pour réaliser une barrière à l'humidité, aux acides et aux solvants, et éventuellement une couche électriquement isolante. Le matériau 152 de la couche de fermeture 150 peut être une colle adaptée éventuellement transparente pour une application optique. La couche 150 de fermeture peut être par exemple une colle optique par exemple de type EPOTEK 302-3M ® ou MASTERBOND® UV11-3.

La couche 150 de fermeture peut être également à base d'un matériau tel que du polyV3D3 (abrégé de poly (1,3,5-trivinyltrimethylcyclotrisiloxane) en vue d'une fermeture à l'aide d'un film continu, conforme, de faible épaisseur, incolore et transparent au rayonnement visible, ainsi que de bonnes propriétés de protection.

Lorsque le matériau 152 de la couche 150 de fermeture est du polyV3D3 ou du parylène, son dépôt peut être réalisé sous une pression comprise entre 1 et 500 mbar, ou sous vide primaire. A une telle pression les liquides de remplissage ont habituellement tendance à s'évaporer. Dans le cas présent, le liquide 130 remplissant les pores du matériau poreux 125 est retenu par capillarité, de sorte que les phénomènes d'évaporation n'apparaissent pas.

Selon un autre exemple, le matériau utilisé pour former la couche de fermeture 150, peut être un matériau bi-composant tel qu'une colle époxy bi-composant, par exemple de type MASTERBOND® EP30. Un premier des composés du matériau bi-composant peut être délivré par exemple par une technique de centrifugation, ou d'étalement de type communément appelé « meniscus coating » ou « blade coating », ou par jet d'encre ou par « spray ».

Le second composé peut, quant à lui, être délivré par exemple par une technique sans contact de type « spray », ou jet d'encre.

Comme indiqué précédemment, on peut former la couche de fermeture dans une partie de l'épaisseur du matériau poreux, par exemple dans un cas où une partie seulement de l'épaisseur de matériau poreux 125 est imprégnée du liquide 130. Cette formation de la couche de fermeture 150 peut être réalisée en délivrant un autre liquide 145 destiné à former une couche de polymère solide, sur le matériau poreux 125 déjà rempli de liquide fonctionnel (figure 2A). L'autre liquide 145 est polymérisable, et de préférence non miscible avec le liquide 130 fonctionnel remplissant les cavités 120. L'autre liquide 145 peut être par exemple une colle polymérisable sous UV destinée à être délivrée à l'aide d'un procédé de type dépôt tournant (« spin coating »), trempage (« dipping »), « spray coating » ou « meniscus coating », par exemple une colle de type Vitralit 6127 ® de la société Eleco. L'autre liquide 145 s'infiltre dans le matériau poreux 125 jusqu'à atteindre le liquide fonctionnel 130 déjà présent. Pour éviter un emprisonnement d'air, un dépôt sous vide peut être réalisé.

Le confinement des porosités du matériau poreux 125 peut permettre d'empêcher un mélange entre le liquide fonctionnel 130 et l'autre liquide 145.

A l'issue de ce dépôt, une couche de fermeture 150 à base de matériau polymère emprisonné dans le matériau poreux est réalisée.

Un exemple de réalisation avec un seul liquide fonctionnel piégé dans le matériau poreux 125 vient d'être donné.

Selon une autre possibilité de mise en oeuvre, une ou plusieurs cavités 120 peuvent être remplies par un mélange de plusieurs liquides, par exemple des encres d'imprimerie déposées par jet d'encre, ou des solutions liquides contenant des molécules fonctionnelles ou par exemple des molécules changeant d'état sous un champ magnétique ou optique.

Selon encore une autre possibilité de mise en oeuvre, plusieurs cavités 120 peuvent être également remplies par des liquides 130, 134, 136 différents d'une cavité à l'autre, par exemple des encres d'imprimerie jet d'encre pour réaliser une fonction de type support d'impression totalement transparent. Cela peut être mis en oeuvre notamment pour une application optique du dispositif, lorsque l'on cherche à conférer aux cavités des propriétés optiques différentes entre elles, comme par exemple pour un filtre optique dans lequel chaque cavité est prévue pour filtrer une gamme de longueurs d'onde spécifique (figure 3).

Selon un autre exemple, un liquide fonctionnel sous forme d'un électrolyte peut être délivré dans les cavités et infiltré dans le matériau poreux 125. Cela peut être effectué par exemple pour réaliser des composants électroniques.

L'un ou l'autre des procédés décrits précédemment peuvent-être utilisés dans de nombreuses applications telles que par exemple pour la réalisation des composants électriques et notamment des super-condensateurs ou des composants adaptés au transfert de charges dans des cellules photovoltaïques organiques

Pour ces applications, des électrodes sur la face supérieure du substrat et sur la face inférieure de la couche de fermeture peuvent être en outre être réalisées. Ces électrodes peuvent être réalisées en pleine couche ou bien être arrangées en matrice à la manière d'un écran plat ou en série à la manière d'une cellule photovoltaïque.

## Revendications

1. Procédé de réalisation d'un dispositif doté d'une ou plusieurs cavités (120) fermées remplies d'au moins un liquide (130) piégé dans un matériau poreux (125) de rétention, comprenant les étapes de :
a) formation d'un matériau poreux (125) dans une ou plusieurs cavités (120) réalisées dans au moins une couche donnée déposée sur un support (100), une ou plusieurs parois formées dans ladite couche séparant entre elles les cavités (120),
b) remplissage d'au moins une des dites cavités à l'aide d'au moins un liquide (130), le liquide étant piégé dans le matériau poreux,
c) formation d'une couche de fermeture (150) permettant de fermer les dites cavités (120).

2. Procédé selon la revendication 1, le matériau poreux (125) et les parois (110) des cavités (120) étant chacun formés à partir de ladite couche donnée.

3. Procédé selon la revendication 2, dans lequel l'étape a) comprend les étapes de :
- dépôt d'une couche d'au moins un matériau donné, tel qu'un matériau sol-gel, le matériau donné étant apte à être mis sous forme de gel et étant photosensible,
- exposition à un rayonnement lumineux de premières parties de la couche dudit matériau donné, tandis que des deuxièmes parties de la couche dudit matériau donné sont protégées dudit rayonnement, les premières parties ou les deuxième parties étant destinées à former lesdites parois des dites cavités,
- formation de porosités dans certaines parties de la couche dudit matériau donné.

4. Procédé selon la revendication 1, dans lequel, après réalisation des dites cavités, la formation du dit matériau poreux (125) à l'étape a) comprend des étapes de :
- dépôt dans au moins une des dites cavités (120) d'un liquide comportant des particules telles que des billes, en suspension,
- suppression du dit liquide, de manière à former un amas de particules, en particulier un amas de billes.

5. Procédé selon la revendication 4, dans lequel, après réalisation desdits cavités, la formation du dit matériau poreux (125) à l'étape a) comprend en outre, des étapes :
- d'infiltration de l'amas de billes par un liquide destiné à être solidifié,
- solidification dudit liquide,
- élimination des dites particules.

6. Procédé selon la revendication 1, dans lequel après formation des dites cavités, la formation du matériau poreux à l'étape a) comprend des étapes de :
- dépôt dans au moins une des dites cavités (120) d'un mélange d'au moins un matériau donné, liquide susceptible d'être mis sous forme de gel et d'au moins un solvant,
- traitement dudit mélange de manière à mettre sous forme de gel ledit matériau donné,
- élimination dudit solvant.

7. Procédé selon l'une des revendications 1 à 6, ladite couche de fermeture (150) étant formée d'un matériau infiltré dans des porosités dudit matériau poreux (125) ou recouvrant ledit matériau poreux (125).

8. Procédé selon l'une des revendications 1 à 7, la couche de fermeture (150) étant formée par polymérisation d'un liquide polymérisable (145) répandu sur ledit matériau poreux (125).

9. Procédé selon l'une des revendications 1 à 8, la couche de fermeture (150) étant réalisée à une pression comprise entre 1 et 500 mbar, ou sous vide primaire.

10. Procédé selon l'une des revendications 1 à 9, dans lequel la couche de fermeture (150) est à base de poly-para-xylylène, de poly(1,3,5-trivinyl trimethyl cyclotrisiloxane), ou d'au moins une colle transparente dans le domaine du rayonnement visible, ou d'au moins une encre polymérisable sous ultraviolet.

11. Procédé selon l'une des revendications 1 à 10, le matériau poreux (125) étant un aérogel ou étant formé à l'aide d'un matériau porogène.

12. Procédé selon l'une des revendications 1 à 11, comportant une étape préalable de formation des parois dans ladite couche puis, dans des zones de cette même couche distinctes des parois, la formation des porosités.

## Patentansprüche

1. Verfahren zur Herstellung einer Vorrichtung, welche mit einer Vielzahl von geschlossenen Hohlräumen (120) versehen ist, welche mit zumindest einer in einem porösen Rückhaltematerial (125) festgehaltenen Flüssigkeit (130) gefüllt sind, wobei das Verfahren die folgenden Schritte aufweist:
a) Bildung eines porösen Materials (125) in einem oder in mehreren Hohlräumen (120), welche in wenigstens einer auf einem Träger (100) aufgebrachten bestimmten Schicht hergestellt sind, wobei eine oder mehrere Wände, welche in dieser Schicht ausgebildet sind, die Hohlräume (120) voneinander trennen;
b) Füllung zumindest einer dieser Hohlräume mit Hilfe einer Flüssigkeit (130), wobei die Flüssigkeit in dem porösen Material eingeschlossen ist; und
c) Bildung einer Deckschicht (150), welche das Verschließen dieser Hohlräume (120) ermöglicht.

2. Verfahren nach Anspruch 1, **dadurch gekennzeichnet, dass** das poröse Material (125) und die Wände (110) der Hohlräume (120) jeweils ab dieser bestimmten Schicht ausgebildet sind.

3. Verfahren nach Anspruch 2, **dadurch gekennzeichnet, dass** der Schritt a) die folgenden Unterschritte aufweist:
- Aufbringen einer Schicht aus zumindest einem bestimmten Material von der Art eines Sol/Gel-Werkstoffs, wobei das bestimmte Material in Gelform umgewandelt werden kann und lichtempfindlich ist;
- Belichtung der ersten Teile der Schicht aus dem bestimmten Material mit einer Lichtstrahlung, während die zweiten Teile der Schicht aus dem bestimmen Material vor dieser Strahlung geschützt werden, wobei die ersten Teile oder die zweiten Teile dazu bestimmt sind, die Wände der Hohlräume zu bilden;
- Ausbildung von Porositäten in gewissen Teilen der Schicht aus dem gegebenen Material.

4. Verfahren nach Anspruch 1, **dadurch gekennzeichnet, dass** nach der Herstellung der Hohlräume die Ausbildung des porösen Materials (125) in Schritt a) die folgenden Unterschritte aufweist:
Ablagerung in zumindest einem dieser Hohlräume (120) einer Flüssigkeit, welche suspendierte Teilchen von der Art von Kugeln aufweist;
Unterdrückung der Flüssigkeit derart, dass eine Anhäufung von Teilchen gebildet wird, insbesondere eine Anhäufung von Kugeln.

5. Verfahren nach Anspruch 4, **dadurch gekennzeichnet, dass** nach der Ausbildung der Hohlräume die Ausbildung des porösen Materials (125) in Schritt a) des Weiteren die folgenden Schritte aufweist:
- Infiltration oder Eindringung derAnhäufung von Kugeln über eine Flüssigkeit, welche dazu bestimmt ist, sich zu verfestigen;
- Verfestigung der Flüssigkeit;
- Beseitigung der Teilchen.

6. Verfahren nach Anspruch 1, **dadurch gekennzeichnet, dass** nach der Ausbildung der Hohlräume die Bildung des porösen Materials bei Schritt a) die folgenden Unterschritte aufweist:
Aufbringung bzw. Ablagerung in zumindest einem dieser Hohlräume (120) eines Gemisches aus zumindest einem bestimmten flüssigen Material, welches dazu geeignet ist, in Gelform versetzt zu werden, und aus zumindest einem Lösungsmittel,
- Behandlung des Gemisches, so dass das bestimmte Material in Gelform versetzt wird,
- Beseitigung des Lösungsmittels.

7. Verfahren nach einem der Ansprüche 1 bis 6, **dadurch gekennzeichnet, dass** die Deckschicht (150) aus einem Material hergestellt ist, welches in die Porositäten des porösen Materials (125) eindringt, oder Bedecken des porösen Materials (125).

8. Verfahren nach einem der Ansprüche 1 bis 7, **dadurch gekennzeichnet, dass** die Deckschicht (150) durch Polymerisation einer polymerisierbaren Flüssigkeit (145), welche auf dem porösen Material (125) verteilt ist, ausgebildet wird.

9. Verfahren nach einem der Ansprüche 1 bis 8, **dadurch gekennzeichnet, dass** die Deckschicht (150) unter einem Druck zwischen 1 und 500 mbar oder unter einem primären Vakuum hergestellt wird.

10. Verfahren nach einem der Ansprüche 1 bis 9, **dadurch gekennzeichnet, dass** die Deckschicht (150) auf der Grundlage von Polyparaxylylen, Poly(1,3,5-Trivinyl-Trimethyl-Cyclotrisiloxan) gebildet ist, oder aus zumindest einem durchsichtigen Klebstoff im Bereich der sichtbaren Strahlung, oder zumindest aus einer unter UV-Strahlung polymerisierbaren Tinte.

11. Verfahren nach einem der Ansprüche 1 bis 10, **dadurch gekennzeichnet, dass** das poröse Material (125) ein Aerogel ist oder mit Hilfe eines Treibmittels hergestellt wird.

12. Verfahren nach einem der Ansprüche 1 bis 11, welches einen Vorschritt der Bildung der Wände in dieser Schicht aufweist, und anschließend in separaten Bereichen derselben Schicht die Bildung von Porositäten.

## Claims

1. Method for producing a device provided with one or more sealed cavities (120) filled with at least one liquid (130) trapped in a porous retention material (125), comprising the steps of:
a) forming a porous material (125) in one or more cavities (120) produced in at least one given layer deposited on a support (100), one or more walls formed in said layer separating between them the cavities (120),
b) filling at least one of said cavities by means of at least one liquid (130), the liquid being trapped in the porous material,
c) forming a sealing layer (150) enabling said cavities (120) to be sealed.

2. Method according to claim 1, the porous material (125) and the walls (110) of the cavities (120) each being formed from said given layer.

3. Method according to claim 2, wherein step a) comprises the steps of:
- depositing a layer of at least one given material, such as a sol-gel material, the given material being suited to being transformed into gel and being photosensitive,
- exposing to a light radiation first parts of the layer of said given material, whereas second parts of the layer of said given material are protected from said radiation, the first parts or the second parts being intended to form said walls of said cavities,
- forming porosities in certain parts of the layer of said given material.

4. Method according to claim 1, wherein, after production of said cavities, the formation of said porous material (125) at step a) comprises steps of:
- depositing in at least one of said cavities (120) a liquid comprising particles such as beads, in suspension,
- eliminating said liquid, so as to form a cluster of particles, in particular a cluster of beads.

5. Method according to claim 4, wherein, after production of said cavities, the formation of said porous material (125) at step a) further comprises, steps:
- of infiltration of the cluster of beads by a liquid intended to be solidified,
- of solidification of said liquid,
- of eliminating said particles.

6. Method according to claim 1, wherein after formation of said cavities, the formation of the porous material at step a) comprises steps of:
- depositing in at least one of said cavities (120) a mixture of at least one given material, liquid capable of being transformed into gel and of at least one solvent,
- treating said mixture so as to transform said given material into gel,
- eliminating said solvent.

7. Method according to one of claims 1 to 6, said sealing layer (150) being formed of a material infiltrated into porosities of said porous material (125) or covering said porous material (125).

8. Method according to one of claims 1 to 7, the sealing layer (150) being formed by polymerization of a polymerizable liquid (145) spread out on said porous material (125).

9. Method according to one of claims 1 to 8, the sealing layer (150) being formed at a pressure between 1 and 500 mbars, or under primary vacuum.

10. Method according to one of claims 1 to 9, wherein the sealing layer (150) is based on poly-para-xylylene, poly(1,3,5-trivinyl trimethyl cyclotrisiloxane), or at least one adhesive transparent in the visible radiation domain, or at least one ink polymerizable under ultraviolet.

11. Method according to one of claims 1 to 10, the porous material (125) being an aerogel or being formed by means of a porogen material.

12. Method according to any of the claims 1 to 11, comprising a prior step of forming the walls in said layer then, forming porosities in zones of said layer.
